(19) Europäisches Patentamt
European Patent Office
Office européen des brevets

(11) **EP 3 497 713 B1**

(12) **FASCICULE DE BREVET EUROPEEN**

(45) Date de publication et mention de la délivrance du brevet:
**08.04.2020 Bulletin 2020/15**

(51) Int Cl.:
***H01L 21/762*** (2006.01)

(21) Numéro de dépôt: **17757806.9**

(86) Numéro de dépôt international:
**PCT/FR2017/052161**

(22) Date de dépôt: **01.08.2017**

(87) Numéro de publication internationale:
**WO 2018/029419 (15.02.2018 Gazette 2018/07)**

(54) **PROCEDE DE TRANSFERT D'UNE COUCHE UTILE**

VERFAHREN ZUR ÜBERTRAGUNG EINER NÜTZLICHEN SCHICHT

METHOD FOR TRANSFERRING A USEFUL LAYER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **11.08.2016 FR 1657722**

(43) Date de publication de la demande:
**19.06.2019 Bulletin 2019/25**

(73) Titulaires:
- **Soitec**
  **38190 Bernin (FR)**
- **Commissariat à l'Énergie Atomique et aux Énergies Alternatives**
  **75015 Paris (FR)**

(72) Inventeurs:
- **LANDRU, Didier**
  **38190 Le Champ-Pres-Froges (FR)**
- **BEN MOHAMED, Nadia**
  **38130 Echirolles (FR)**
- **KONONCHUK, Oleg**
  **38570 Theys (FR)**
- **MAZEN, Frédéric**
  **38120 Saint Egreve (FR)**
- **MASSY, Damien**
  **38300 Saint Ismier (FR)**
- **REBOH, Shay**
  **38054 Grenoble (FR)**
- **RIEUTORD, François**
  **38120 Saint Egreve (FR)**

(74) Mandataire: **IP Trust**
**2, rue de Clichy**
**75009 Paris (FR)**

(56) Documents cités:
**EP-A1- 2 933 828**

- **MASSY D ET AL: "Fracture dynamics in implanted silicon", APPLIED PHYSICS LETTERS, A I P PUBLISHING LLC, US, vol. 107, no. 9, 31 août 2015 (2015-08-31), XP012200151, ISSN: 0003-6951, DOI: 10.1063/1.4930016 [extrait le 1901-01-01]**
- **XI-QIAO FENG ET AL: "Mechanics of Smart-Cut technology", INTERNATIONAL JOURNAL OF SOLIDS AND STRUCTURES, vol. 41, no. 16-17, 1 août 2004 (2004-08-01), pages 4299-4320, XP055158893, ISSN: 0020-7683, DOI: 10.1016/j.ijsolstr.2004.02.054**

## Description

## DOMAINE DE L'INVENTION

La présente invention concerne un procédé de transfert d'une couche utile.

## ARRIERE PLAN TECHNOLOGIQUE DE L'INVENTION

On connaît du document FR3020175 un procédé de transfert d'une couche utile 3 sur un substrat support 4, représenté sur la figure 1, ce procédé comprenant les étapes principales suivantes :

- dans une étape a), la formation d'un plan de fragilisation 2 par implantation d'espèces légères dans un premier substrat 1 de manière à former une couche utile 3 entre ce plan et une surface du premier substrat ;
- dans une étape b), l'application du support 4 sur la surface du premier substrat 1 pour former un ensemble à fracturer 5 présentant deux faces exposées S1, S2 ;
- dans une étape c), le traitement thermique de fragilisation de l'ensemble à fracturer 5 ;
- dans une étape d), l'initiation et propagation auto-entretenue d'une onde de fracture dans le premier substrat 1 le long du plan de fragilisation 2.

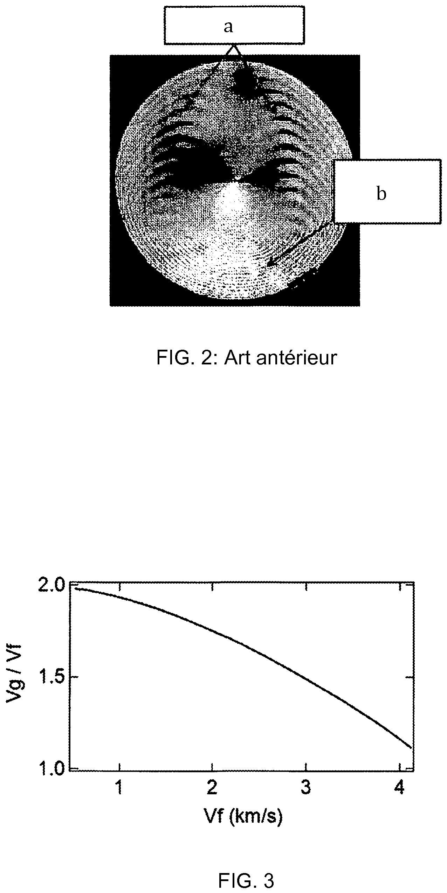

Selon ce document, des vibrations acoustiques sont émises lors de l'initiation et/ou lors de la propagation de l'onde de fracture. L'interaction entre la propagation de l'onde de fracture et ces vibrations acoustiques, conduit à la formation de motifs périodiques de variations d'épaisseur de la couche utile formée, qui s'étendent sur toute la surface de cette couche. En d'autres termes, l'onde de fracture est déviée verticalement de son plan de progression selon l'état des contraintes instantanées du matériau qu'elle traverse, cet état de contrainte étant influencé par l'onde acoustique. La figure 2 représente ainsi les motifs de variations d'épaisseur d'une couche utile transférée selon le procédé qui vient d'être présenté. Dans l'exemple représenté, les motifs comprennent des motifs latéraux et circulaires (respectivement désignés a et b sur cette figure). Ces motifs ont été rendus apparents par la mesure de bruit de fond diffus (« haze » selon la terminologie anglo-saxonne communément employée) correspondant à l'intensité de la lumière diffusée par la surface de la couche, à l'aide de l'outil d'inspection Surfscan™ de la société KLA-Tencor. On pourra se référer à l'article « Seeing through the haze », de F. Holsteyns, Yield Management Solution, Spring 2004, pp50-54 pour une information plus complète sur cette technique d'inspection.

Pour remédier à ce problème, le document précité prévoit de munir l'ensemble à fracturer d'élément absorbant pour capter et dissiper l'onde acoustique émise, et prévenir ou limiter la formation de ces motifs de variation d'épaisseur de la couche utile. Bien que ce procédé soit tout à fait efficace, il nécessite toutefois la mise en œuvre d'un élément absorbant sur l'une au moins des faces de l'ensemble à fracturer, ce qui complexifie le procédé de transfert de la couche utile.

## OBJET DE L'INVENTION

Un but de l'invention est de proposer un procédé simple de transfert d'une couche utile, cette couche utile présentant un motif de variations d'épaisseur d'étendue réduite.

## BREVE DESCRIPTION DE L'INVENTION

En vue de la réalisation de ce but, l'objet de l'invention propose un procédé de transfert d'une couche utile sur un support comprenant les étapes suivantes de :

- formation d'un plan de fragilisation par implantation d'espèces légères dans un premier substrat, de manière à former une couche utile entre ce plan et une surface du premier substrat ;
- application du support sur la surface du premier substrat pour former un ensemble à fracturer;
- traitement thermique de fragilisation de l'ensemble à fracturer;
- initiation et propagation d'une onde de fracture dans le premier substrat le long du plan de fragilisation.
- la vitesse de propagation de l'onde de fracture est contrôlée pour présenter une vitesse supérieure au tiers de la vitesse de l'onde acoustique ;

Le procédé est remarquable en ce que l'initiation de l'onde de fracture est située dans une zone centrale du plan de fragilisation et en ce que la vitesse de propagation de l'onde de fracture est contrôlée pour présenter une vitesse suffisante. De la sorte, les interactions de l'onde de fracture avec des vibrations acoustiques émises lors de son initiation et/ou de sa propagation sont limitées à une zone périphérique de la couche utile (3).

L'invention permet de confiner la formation des motifs périodiques de variation d'épaisseur à une partie seulement de la couche utile.

Selon d'autres caractéristiques avantageuses et non limitatives de l'invention, prises seules ou selon toute combinaison techniquement réalisable :

- le premier substrat est en silicium et la propagation de l'onde de fracture est contrôlée pour présenter une vitesse supérieure à 2 km/s ;

- la propagation de l'onde de fracture est contrôlée pour présenter une vitesse comprise entre 2km/s et 4,5km/s, préférentiellement entre 3,8km/s et 4,2km/s ;

- l'initiation de l'onde de fracture est obtenue par application du traitement thermique de fragilisation et le contrôle de la vitesse de propagation est obtenu en choisissant la température de ce traitement thermique au moment de l'initiation ;

- la température de traitement thermique de fragilisation est supérieure à 400° ou à 500°C ;

- l'initiation de l'onde de fracture est provoquée par une amorce de fracture disposée dans la zone centrale du plan de fragilisation, ou à proximité de cette zone centrale ;

- l'amorce de fracture est formée d'un volume présentant un excès d'espèces légères comparativement à la concentration moyenne dans le plan de fragilisation ;

- l'amorce de fracture est formée d'une cavité ou d'un corps disposé à l'interface entre le premier substrat et le support au droit de la zone centrale du plan de fragilisation ;

- l'onde de fracture est initiée par un apport d'énergie localisée au niveau de la zone centrale du plan de fragilisation ;

- le contrôle de la vitesse de propagation est obtenu en calibrant le traitement thermique de fragilisation pour que le plan de fragilisation présente un taux de maturation au moins égale à un taux de maturation cible;

- le premier substrat est formé d'une plaquette en forme de disque, et dans lequel la zone centrale comprend le centre géométrique de la plaquette ;

- la zone périphérique est formée d'une zone annulaire dont le rayon du cercle interne est supérieur à 2/3, et préférentiellement supérieure à 80%, du rayon du premier substrat ;

- la zone périphérique est entièrement comprise dans une zone d'exclusion de la couche utile.

## BREVE DESCRIPTION DES DESSINS

D'autres caractéristiques et avantages de l'invention ressortiront de la description détaillée de l'invention qui va suivre en référence aux figures annexées sur lesquels :

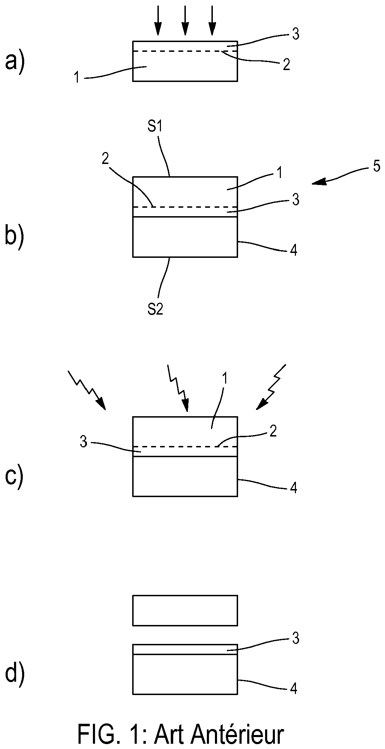

- La figure 1 représente un procédé de transfert d'une couche utile selon l'état de la technique ;

- la figure 2 représente une vue du bruit de fond diffus émis par une couche utile de l'état de la technique faisant apparaître les motifs périodiques de variation d'épaisseur;

- la figure 3 représente un graphe de la relation expérimentale reliant la vitesse de l'onde de fracture et la vitesse de l'onde acoustique ;

- La figure 4 représente un procédé de transfert d'une couche utile conforme à l'invention ;

- La figure 5a représente une vue du bruit de fond diffus émis par une couche utile obtenue par un procédé conforme à l'invention ;

- La figure 5b représente une vue d'une couche utile obtenue par simulation d'un procédé conforme à l'invention.

## DESCRIPTION DETAILLEE DE L'INVENTION

Les inventeurs de la présente demande ont étudié avec grande précision les phénomènes décrits en relation avec la présentation de l'état de la technique pour proposer un procédé original de transfert d'une couche utile. Selon cette approche originale, il n'est pas recherché de limiter le développement de l'onde acoustique, par exemple en la captant et/ou en l'absorbant, mais de limiter son interaction avec l'onde de fracture. On confine ainsi la formation des motifs périodiques de variation d'épaisseur à une partie seulement de cette couche.

Les inventeurs ont ainsi noté que l'onde acoustique se propageait, à partir du point d'initiation de la fracture, à une vitesse supérieure à celle de l'onde de fracture, et que l'origine du motif ondulatoire provenait des interférences issues de la rencontre entre l'onde de fracture et les réflexions, sur les extrémités de l'ensemble à fracturer, de l'onde acoustique. Les caractéristiques de propagation de l'onde acoustique, et notamment sa vitesse, peuvent se mesurer à l'aide de capteurs piézoélectriques positionnés sur une et/ou l'autre face de l'ensemble à fracturer.

Pour limiter ces interférences, l'invention propose d'une part d'éloigner le point d'initiation de la fracture des extrémités de l'ensemble à fracturer, c'est-à-dire de placer ce point d'initiation à distance des bords des substrats, au niveau d'une zone centrale du plan de fragilisation. On retarde ainsi, à partir du moment d'initiation de fracture, l'instant auquel l'onde acoustique réfléchie rencontre l'onde de fracture.

Simultanément, l'invention propose de contrôler la vitesse de propagation de l'onde de fracture. Celle-ci est choisie suffisamment élevée pour que la zone de rencontre entre l'onde de fracture et l'onde acoustique réfléchie (qui présentera les motifs périodiques de variation d'épaisseur de la couche utile) soit confinée dans une zone périphérique de l'ensemble à fracturer. Dans les situations les plus favorables, en particulier si la vitesse de l'onde de fracture est suffisamment élevée, cette zone périphérique peut être comprise dans une zone d'exclusion de la couche utile, c'est-à-dire une zone où il n'est généralement pas prévu de former des composants. Cette zone d'exclusion peut avoir une étendue de 0,5 à 2 ou 3 millimètres en périphérie de la couche utile. La surface de la couche utile non comprise dans la zone périphérique est quant à elle essentiellement exempte de motifs périodiques et présente donc les caractéristiques requises d'uniformité d'épaisseur.

On notera que le principe de l'invention repose sur l'hypothèse, vérifiée par les inventeurs de la présente demande, que la vitesse de propagation de l'onde acoustique n'est pas directement liée (par exemple proportionnellement) à la vitesse de propagation de l'onde de fracture.

En effet, si on considère un ensemble à fracturer de contour circulaire et de rayon R, que l'on note Vg la vitesse de l'onde acoustique dans le plan défini par l'ensemble à fracturer et Vf la vitesse de l'onde de fracture, alors la distance d entre le centre de l'ensemble à fracturer (d'où s'initie la fracture) et le lieu de rencontre des deux ondes satisfait l'équation :

$$d/Vf = (2R-d)/Vg$$

en posant qu'au lieu de rencontre, l'onde de fracture a parcouru une distance d à la vitesse Vf et l'onde acoustique réfléchie a parcouru la distance (2R - d) à la vitesse Vg. On peut ainsi déterminer que cette distance d satisfait l'équation :

$$d = 2R/(1+Vg/Vf)$$

On note donc que cette distance d peut être contrôlée et s'approcher au plus près de R, dans la mesure où le ratio Vg/Vf peut-être lui-même contrôlé pour s'approcher de 1.

La figure 3 présente des résultats d'expérimentation réalisée par les inventeurs en préparation de la présente invention, présentant le rapport Vg/Vf pour différentes vitesses Vf de l'onde de fracture. Ces mesures ont été obtenues lorsque le procédé de transfert de couche est appliqué à un premier substrat en silicium.

On observe qu'il est possible de choisir le ratio Vg/Vf dans une large gamme comprise entre 1 et 2, en choisissant la valeur de la vitesse de l'onde de fracture Vf. Pour une faible vitesse de l'onde de fracture, de l'ordre de 1km/s, la vitesse de l'onde acoustique est près de 2 fois supérieure (Vg/Vf proche de 2). En conséquence, la zone de rencontre est une zone annulaire dont le rayon interne est égal à 2/3 du rayon R de l'ensemble à fracturer.

Pour une vitesse élevée de l'onde de fracture, la vitesse de l'onde acoustique est légèrement supérieure à celle de l'onde de fracture (Vg/VF proche de 1). La zone de rencontre est alors confinée à une zone annulaire dont le rayon interne est très proche du rayon R de l'ensemble à fracturer, et donc quasiment inexistant.

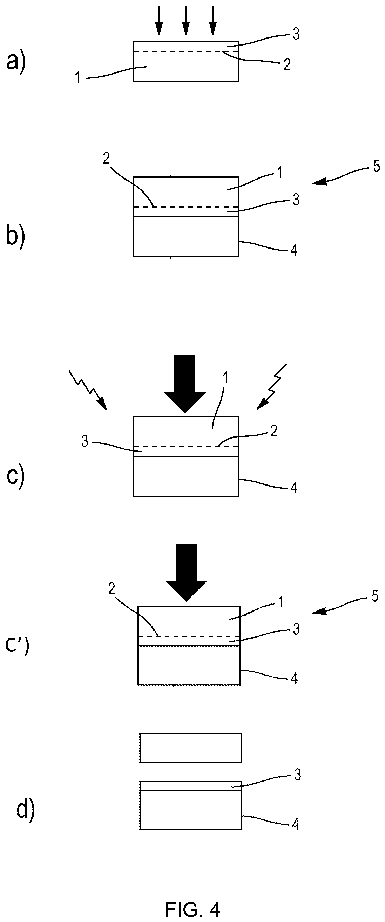

Sur la base de cette étude, l'invention propose un procédé de transfert d'une couche utile 3 sur un support 4 comprenant les étapes représentées sur les figures 4a à 4d.

Dans une première étape a), représentée sur la figure 4a, on forme un plan de fragilisation 2, par exemple par implantation d'espèces légères dans le premier substrat 1. Le premier substrat 1 peut être en silicium, ou en tout autre matériau semi-conducteur ou non. Il peut s'agir par exemple de germanium, de nitrure de gallium, de tantalate de lithium, de saphir. Des couches peuvent avoir été disposées préalablement en surface par dépôt ou par traitement thermique. Il peut s'agir d'une couche de dioxyde de silicium, obtenue par oxydation thermique d'une plaquette en silicium ou d'une couche obtenue par dépôt épitaxial de toute nature : SiGe ; InGaN ; AlGaN, Ge, etc.

Le premier substrat 1 peut avoir la forme d'une plaquette, circulaire, de dimension normalisée, par exemple de 200 mm ou 300 mm, voire 450 mm de diamètre. Mais l'invention n'est nullement limitée à ces dimensions ou à cette forme.

Quant aux espèces légères, il peut s'agir de toutes espèces aptes à fragiliser le premier substrat 1 au niveau de son plan de fragilisation. Il peut notoirement s'agir d'hydrogène et/ou d'hélium.

Le plan de fragilisation 2 délimite avec une surface du premier substrat la couche utile 3.

Dans une seconde étape b), on applique ensuite un support 4 sur la surface du premier substrat 1 pour former l'ensemble à fracturer 5. Le support peut être constitué d'une plaquette de silicium, ou d'un substrat en tout autre matériau et de toute forme, par exemple en saphir ou en verre. Comme pour le premier substrat 1, le support 4 peut avoir été préalablement muni de couches superficielles de toute nature.

L'application du support 4 sur la surface du premier substrat peut être réalisée par toute méthode d'assemblage direct : par adhésion moléculaire, par thermo compression, par collage électrostatique, etc. Il peut également comprendre l'application d'une couche adhésive sur le support 4 et/ou le premier substrat 1, telle qu'une colle. L'application du support 4 peut également correspondre au dépôt d'un matériau à la surface du premier substrat 1, la couche déposée formant le support 4.

Dans une étape suivante c), on applique ensuite à l'ensemble à fracturer 5 un traitement thermique de fragilisation. Ce traitement thermique fragilise le premier substrat 1 au niveau de son plan de fragilisation 2, et fournit l'énergie suffisante pour que l'onde de fracture, une fois initiée, se propage de manière auto-entretenue. Ce traitement thermique est typiquement compris entre 150°C et 600°C pendant une durée de 30 minutes à 8 heures, par exemple pendant 4 heures à 400°C.

Dans une première variante de mise en œuvre, le traitement thermique est suffisant à lui seul pour initier l'onde de fracture. A l'issue du traitement thermique, la couche utile 3 est entièrement détachée du premier substrat 1, comme représenté sur la figure 4d.

Dans une seconde variante de mise en œuvre, correspondant à la figure 4c', le procédé comprend un apport additionnel localisé, après ou pendant le traitement thermique de fragilisation, pour initier l'onde de fracture. Cette énergie peut être d'origine mécanique, thermique ou de toute autre origine. Il peut s'agir par exemple d'un chauffage localisé réalisé par un laser, ou d'un apport d'énergie par ultrasons.

Quelle que soit la variante mise en œuvre, l'onde de fracture, une fois initiée, se propage de manière auto-entretenue pour détacher et transférer la couche utile 2 sur le support 4, comme cela est représenté en étape d) de la figure 4.

Selon l'invention, l'initiation de l'onde de fracture qui se produit au cours d'une des étapes représentées sur les figures 4c et 4c', est située dans une zone centrale du plan de fragilisation 2. Cette initiation dans la zone centrale est symbolisée sur ces figures par des flèches épaisses.

Il n'est pas nécessaire que l'onde de fracture soit précisément initiée au centre géométrique de ce plan 2. Ainsi, la zone centrale d'initiation peut correspondre à une surface circulaire centrée sensiblement sur le centre géométrique du plan de fragilisation. Cette surface peut correspondre à 20%, 10 % ou 5 % de la surface totale du plan de fragilisation 2. Comme on l'a présenté précédemment, lorsque la fracture est initiée au niveau d'un point de cette zone, elle est suffisamment distante des bords de l'ensemble à fracturer 5 pour retarder l'instant auquel l'onde de fracture interagit avec l'onde acoustique réfléchie.

Plusieurs approches sont possibles pour provoquer l'initiation de la fracture dans cette zone centrale. Il est ainsi possible de disposer une amorce de fracture dans cette zone ou à proximité de cette zone, dans une étape préalable à l'étape de traitement thermique. Au cours de cette étape, l'amorce de fracture forme un lieu privilégié d'initiation de cette fracture.

Cette amorce peut ainsi être formée en introduisant des espèces légères dans le premier substrat 1 au niveau de la zone centrale du plan de fragilisation 2. On forme de la sorte un volume, définissant l'amorce, présentant un excès d'espèces légères comparativement à la concentration moyenne du plan de fragilisation 2. Cet excès d'espèces légères peut être introduit avant, pendant ou après l'étape de formation du plan de fragilisation 2, et dans tous les cas avant l'étape d'assemblage. L'amorce peut présenter une dimension principale de 10 nm à quelques millimètres. Les espèces en excès peuvent être introduites dans le premier substrat 1 par implantation localisée, avec ou sans masquage préalable de ce substrat 1. À titre d'exemple, une implantation localisée d'hydrogène sur une surface de 1 mm de diamètre, d'une dose (additionnelle à celle formant le plan fragilisation) de 1e16 at/cm$^2$ permet d'y initier la fracture au cours de l'étape de traitement thermique de fragilisation, précisément au niveau de cette zone surimplantée formant l'amorce.

L'amorce peut également être formée au niveau de l'interface d'assemblage du premier substrat 1 et du support 4, au droit de la zone centrale du plan de fragilisation 2. Elle peut consister en une cavité, par exemple formée par gravure, en surface du premier substrat 1 ou du support 4, ou encore en un corps de dimensions réduites disposé à cette interface. La présence de ce corps ou de cette cavité engendre des contraintes locales au cours du traitement thermique de fragilisation favorisant l'initiation de l'onde de fracture dans la zone centrale, comme cela est par exemple exposé dans le document US2010330779.

Dans le cas où l'onde de fracture est provoquée au cours de l'étape de traitement thermique de fragilisation par la présence d'une amorce, ce traitement thermique peut être appliqué uniformément à l'ensemble à fracturer 5.

Dans une variante à l'insertion d'une amorce de fracture, ou en complément, l'initiation peut être provoquée par un apport local d'énergie au niveau de la zone centrale pendant ou après l'étape de traitement thermique de fragilisation. Il peut ainsi s'agir de configurer l'équipement de traitement thermique pour que la zone centrale reçoive, pendant ce traitement, une énergie thermique supérieure à celle reçue par la zone périphérique.

Il peut également s'agir d'appliquer localement l'énergie par un faisceau lumineux (un laser par exemple) ou un faisceau de particules (ions, électrons).

Il peut s'agir encore d'appliquer au niveau de la zone centrale un apport d'énergie d'origine mécanique comme par exemple des vibrations transmises par un générateur ultrason, par exemple piézo-électrique.

Dans ces deux derniers exemples, l'application locale d'énergie peut être réalisée au cours de l'étape de traitement thermique de fragilisation ou au cours d'une éventuelle étape additionnelle dédiée à cette application locale d'énergie.

Quel que soit le mode de mise en œuvre choisi pour initier la fracture au niveau de la zone centrale du plan de fragilisation 2, l'invention comprend également le contrôle de la vitesse de propagation de l'onde de fracture pour qu'elle présente une vitesse suffisante, limitant les interactions avec les vibrations acoustiques émises lors de son initiation et/ou de sa propagation.

Comment on l'a exposé précédemment, une vitesse suffisante permet de confiner ces interactions dans une zone périphérique. Et plus cette vitesse est importante, et plus la zone périphérique est réduite en surface. On confine de la sorte les motifs périodiques de variation d'épaisseur à cette zone périphérique de la couche utile 3. Ainsi, lorsque le premier substrat est en silicium, il est avantageux que la propagation de l'onde de fracture soit contrôlée pour présenter une vitesse supérieure à 2 km/s et préférentiellement comprise entre 2 et 4,5 km/s ou encore plus préférentiellement égale ou proche de 4 km/s, par exemple entre 3,8 et 4,2 km/s.

D'une manière plus générale, et selon l'invention, on contrôlera la vitesse de l'onde de fracture pour qu'elle soit supérieure ou égale au tiers de la vitesse de l'onde acoustique (i.e Vg/3), de manière à ce que la zone périphérique, dans laquelle sont confinés les motifs périodiques, soit inférieure à R/2.

Suivant la méthode d'initiation de fracture qui a été choisie (thermique et/ou mécanique) on pourra choisir les paramètres opérationnels de cette méthode pour contrôler la vitesse de propagation de l'onde de fracture. À ce titre on pourra se faire aider du dispositif de mesure de la vitesse d'onde de fracture décrit dans le document WO2013140065.

Ainsi, lorsque l'initiation de la fracture est obtenue en température, par exemple lorsque le traitement thermique de fragilisation provoque à lui seul cette initiation, on pourra se référer au document « fracture dynamics in implanted silicon » de D. Massy et Al, Applied Physics Letters 107 (2015), pour choisir la température permettant d'obtenir la vitesse d'onde de fracture visée. En particulier, on pourra choisir une température supérieure à 400°C ou à 500°C. Ce document présente une méthodologie permettant de relier la vitesse de propagation de l'onde de fracture suivant les paramètres opérationnels de fragilisation et/ou d'initiation de l'onde. Il rapporte en particulier que, dans le cas d'un premier substrat en silicium, la vitesse de propagation de l'onde de fracture peut être contrôlée entre environ 1 km/s et 4 km/s lorsque la température au moment de l'initiation de la fracture varie entre environ 300° et 700°.

Dans la seconde variante de mise en œuvre comprenant un apport d'énergie localisé pour initier l'onde de fracture, on pourra jouer sur le taux de maturation du plan de fragilisation, obtenu à l'issue du traitement thermique de fragilisation. Le taux de maturation correspond à la surface couverte par des microfissures formées dans le plan de fragilisation, au moment de l'application de l'énergie localisée provoquant l'initiation de la fracture. La vitesse de propagation de l'onde de fracture dépend en effet du taux de maturation : plus ce paramètre sera important, plus la vitesse de propagation de l'onde de fracture sera importante.

Pour calibrer le traitement thermique de fragilisation permettant d'atteindre une vitesse de fracture cible, il est possible de mesurer le taux de maturation en mesurant la surface couverte par les microfissures, par exemple, au microscope infrarouge. On pourra alors ajuster ce traitement thermique pour que la zone de fragilisation présente un taux de maturation au moins égale à un taux de maturation cible, permettant d'atteindre ou de dépasser une vitesse de fracture visée.

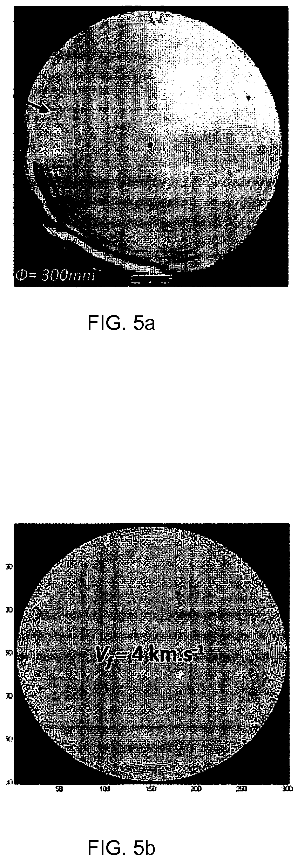

La figure 5a représente une vue du bruit de fond diffus émis par une couche utile obtenue par un procédé conforme à l'invention.

La couche utile 3 de la figure 5a résulte d'un procédé comprenant une étape de formation d'une amorce de fracture par implantation d'une dose de 1.10^16 at/cm² d'hydrogène au centre géométrique d'un premier substrat constitué d'une plaquette de silicium. Après assemblage à un support également constitué d'une plaquette de silicium, la fracture s'est initiée au niveau de l'amorce au cours d'un traitement thermique de fragilisation mené à 350°C pendant 30 heures.

L'onde de fracture s'est propagée à une vitesse de l'ordre de 2.8 km /s.

On observe que la couche utile représentée sur cette figure 5a présente des motifs périodiques de variation d'épaisseur qui sont confinés à une zone annulaire périphérique dont le rayon du cercle intérieur est plus grand que 80% du rayon de la couche utile. La surface centrale de la couche utile est quant à elle exempte de motifs périodiques de variation d'épaisseur.

La figure 5b représente quant à elle une vue d'une couche utile obtenue par simulation d'un procédé conforme à l'invention, lorsque l'onde de fracture est propagée à 4km/s.

On observe sur cette représentation de la couche utile 3, que celle-ci présente en périphérie une zone annulaire très étroite comprenant les motifs périodiques de variation d'épaisseur.

Cette dernière figure illustre parfaitement le bénéfice qu'il est possible de retirer de la présente invention pour former une couche utile présentant des propriétés d'uniformité améliorées.

## Revendications

1. Procédé de transfert d'une couche utile (3) sur un support (4) comprenant les étapes suivantes de :

   - formation d'un plan de fragilisation (2) par implantation d'espèces légères dans un premier substrat (1), de manière à former une couche utile (3) entre ce plan (2) et une surface du premier substrat (1) ;
   - application du support (4) sur la surface du premier substrat (1) pour former un ensemble à fracturer (5);
   - traitement thermique de fragilisation de l'ensemble à fracturer (5) ;
   - initiation et propagation d'une onde de fracture dans le premier substrat (1) le long du plan de fragilisation (2) ;

   le procédé étant **caractérisé en ce que** :

   - l'initiation de l'onde de fracture est située dans une zone centrale du plan de fragilisation (2) ; et
   - la vitesse de propagation de l'onde de fracture est contrôlée pour présenter une vitesse supérieure au tiers de la vitesse de l'onde acoustique ;

de sorte que les interactions de l'onde de fracture avec des vibrations acoustiques émises lors de son initiation et/ou de sa propagation soient limitées à une zone périphérique de la couche utile (3).

2. Procédé selon l'une des revendications précédentes dans lequel le premier substrat (1) est en silicium et dans lequel la propagation de l'onde de fracture est contrôlée pour présenter une vitesse supérieure à 2 km/s.

3. Procédé selon la revendication précédente dans lequel la propagation de l'onde de fracture est contrôlée pour présenter une vitesse comprise entre 2km/s et 4,5km/s.

4. Procédé selon la revendication 3 dans lequel la propagation de l'onde de fracture est contrôlée pour présenter une vitesse comprise entre 3,8km/s et 4,2km/s.

5. Procédé selon l'une des revendications précédentes dans lequel l'initiation de l'onde de fracture est obtenue par application du traitement thermique de fragilisation et dans lequel le contrôle de la vitesse de propagation est obtenu en choisissant la température de ce traitement thermique au moment de l'initiation.

6. Procédé selon la revendication précédente dans lequel la température de traitement thermique de fragilisation est supérieure à 400° ou à 500°C.

7. Procédé selon l'une de revendications précédentes dans lequel l'initiation de l'onde de fracture est provoquée par une amorce de fracture disposée dans la zone centrale du plan de fragilisation (2), ou à proximité de cette zone centrale.

8. Procédé selon la revendication précédente dans lequel l'amorce de fracture est formée d'un volume présentant un excès d'espèces légères comparativement à la concentration moyenne dans le plan de fragilisation (2).

9. Procédé selon la revendication 8 dans lequel l'amorce de fracture est formée d'une cavité ou d'un corps disposé à l'interface entre le premier substrat (1) et le support (5) au droit de la zone centrale du plan de fragilisation (2).

10. Procédé selon l'une des revendications 1 à 7 dans lequel l'onde de fracture est initiée par un apport d'énergie localisée au niveau de la zone centrale du plan de fragilisation (2).

11. Procédé selon la revendication précédente dans lequel le contrôle de la vitesse de propagation est obtenu en calibrant le traitement thermique de fragilisation pour que le plan de fragilisation présente un taux de maturation au moins égale à un taux de maturation cible.

12. Procédé selon l'une des revendications précédentes dans lequel le premier substrat (1) est formé d'une plaquette en forme de disque, et dans lequel la zone centrale comprend le centre géométrique de la plaquette.

13. Procédé selon des revendications précédentes dans lequel la zone périphérique est formée d'une zone annulaire dont le rayon du cercle interne est supérieur à 2/3, et préférentiellement supérieure à 80%, du rayon du premier substrat (1).

14. Procédé selon la revendication précédente dans lequel la zone périphérique est entièrement comprise dans une zone d'exclusion de la couche utile (3).

**Patentansprüche**

1. Verfahren zur Übertragung einer Nutzschicht (3) auf einen Träger (4), wobei dieses Verfahrens folgende Schritte umfasst:

   - die Bildung einer Versprödungsebene (2) durch Implantieren leichter Spezies in ein erstes Substrat (1), um so eine Nutzschicht (3) zwischen dieser Ebene (2) und einer Oberfläche des ersten Substrats (1) zu bilden;
   - das Aufbringen des Trägers (4) auf der Oberfläche des ersten Substrats (1), um eine zu brechende Anordnung (5) zu bilden;
   - die Versprödungswärmebehandlung der zu brechenden Anordnung (5);
   - die Initiierung und Ausbreitung einer Bruchwelle im ersten Substrat (1) entlang der Versprödungsebene (2),

   wobei das Verfahren **dadurch gekennzeichnet ist, dass**:

   - die Bruchwelle in einem zentralen Bereich der Versprödungsebene (2) initiiert wird; und
   - die Ausbreitungsgeschwindigkeit der Bruchwelle so gesteuert wird, dass ihre Geschwindigkeit größer als ein Drittel der Geschwindigkeit der akustischen Welle ist,

   so dass die Wechselwirkungen der Bruchwelle mit den bei ihrer Initiierung und/oder Ausbreitung emittierten akustischen Schwingungen auf einen Randbereich der Nutzschicht (3) begrenzt sind.

2. Verfahren nach einem der vorhergehenden Ansprüche, in dem das erste Substrat (1) aus Silizium besteht und die Ausbreitung der Bruchwelle so gesteuert wird, dass sie eine Geschwindigkeit größer 2 km/s hat.

3. Verfahren nach dem vorhergehenden Anspruch, in dem die Ausbreitung der Bruchwelle so gesteuert wird, dass sie eine Geschwindigkeit zwischen 2km/s und 4,5km/s aufweist.

4. Verfahren nach Anspruch 3, bei dem die Ausbreitung der Bruchwelle so gesteuert wird, dass sie eine Geschwindigkeit zwischen 3,8 km/s und 4,2 km/s aufweist.

5. Verfahren nach einem der vorhergehenden Ansprüche, in dem die Initiierung der Bruchwelle durch Anwendung der Versprödungswärmebehandlung erreicht wird und die Steuerung der Ausbreitungsgeschwindigkeit durch die Wahl der Temperatur dieser Wärmebehandlung zum Zeitpunkt der Initiierung erreicht wird.

6. Verfahren nach dem vorhergehenden Anspruch, in dem die Temperatur der Versprödungswärmebehandlung über 400° oder 500°C liegt.

7. Verfahren nach einem der vorhergehenden Ansprüche, in dem die Initiierung der Bruchwelle durch eine Brucheinleitung im zentralen Bereich der Versprödungsebene (2) oder in der Nähe dieses zentralen Bereiches herbeigeführt wird.

8. Verfahren nach einem der vorhergehenden Ansprüche, in dem die Brucheinleitung gebildet wird durch ein Volumen, das im Vergleich zur durchschnittlichen Konzentration auf der Versprödungsebene (2) einen Überschuss an leichten Spezies aufweist.

9. Verfahren nach Anspruch 8, in dem die Brucheinleitung durch einen Hohlraum oder einen Körper gebildet wird, der an der Grenzfläche zwischen dem ersten Substrat (1) und dem Träger (5) im zentralen Bereich der Versprödungsebene (2) angeordnet ist.

10. Verfahren nach einem der Ansprüche 1 bis 7, in dem die Bruchwelle durch eine lokalisierte Zufuhr von Energie im zentralen Bereich der Versprödungsebene (2) initiiert wird.

11. Verfahren nach dem vorhergehenden Anspruch, in dem die Steuerung der Ausbreitungsgeschwindigkeit durch Kalibrieren der Versprödungswärmebehandlung erreicht wird, so dass die Versprödungsebene einen Reifegrad aufweist, der mindestens gleich einem Zielreifegrad ist.

12. Verfahren nach einem der vorhergehenden Ansprüche, in dem das erste Substrat (1) aus einem scheibenförmigen Plättchen gebildet wird, und der zentrale Bereich die geometrische Mitte des Plättchens umfasst.

13. Verfahren nach den vorhergehenden Ansprüchen, in dem die Randzone durch eine Ringzone gebildet wird, deren Innenkreisradius größer als 2/3 und vorzugsweise größer als 80% des Radius des ersten Substrats (1) ist.

14. Verfahren nach dem vorhergehenden Anspruch, in dem die Randzone vollständig in einem Bereich gelegen ist, in dem die Nutzschicht (3) nicht enthalten ist.

## Claims

1. A method for transferring a useful layer (3) onto a support (4) comprising the following steps:

    - forming a fragilisation plane 2 by implanting light species in a first substrate 1, so as to form a useful layer 3 between this plane and a surface of the first substrate 1;
    - applying the support (4) onto the surface of the first substrate (1) so as to form an assembly to be fractured (5);
    - fragilisation heat treating the assembly to be fractured (5);
    - initiating and propagating a fracture wave in the first substrate (1) along the fragilisation plane (2);

    with the method being **characterised in that**:

    - the initiation of the fracture wave is located in a central zone of the fragilisation plane (2); and
    - the propagation speed of the fracture wave is controlled so as to have a speed higher than one third of the speed of the acoustic wave;

    so that the interactions of the fracture wave with acoustic vibrations emitted during its initiation and/or its propagation are limited to a peripheral zone of the useful layer (3).

2. A method according to one of the preceding claims, wherein the first substrate (1) is made of silicon, and wherein the propagation of the fracture wave is controlled so as to have a speed above 2km/sec.

3. A method according to the preceding claim, wherein the propagation of the fracture wave is controlled so as to have a speed ranging from 2km/sec to 4.5km/sec.

4. A method according to claim 3, wherein the propagation of the fracture wave is controlled so as to have a speed ranging from 3.8km/sec to 4.2km/sec.

5. A method according to one of the preceding claims, wherein the initiation of the fracture wave is obtained by applying the fragilisation heat treatment and wherein the propagation speed is controlled by selecting the temperature of such heat treatment at the time of the initiation.

6. A method according to the preceding claim, wherein the temperature of the fragilisation heat treatment is above 400°C, or 500°C.

7. A method according to one of the preceding claims, wherein the initiation of the fracture wave is caused by an incipient fracture placed in the central zone of the fragilisation plane (2),

8. A method according to the preceding claim, wherein the incipient fracture consists of a volume containing light species in excess as compared to the average concentration in the fragilisation plane (2).

9. A method according to claim 8, wherein the incipient fracture consists of a cavity or a body positioned at the interface between the first substrate (1) and the support (5) in line with the central zone of the fragilisation plane (2).

10. A method according to one of claims 1 to 7, wherein the fracture wave is initiated by energy input at the central zone of the fragilisation plane (2).

11. A method according to the preceding claim, wherein the control of the propagation speed is obtained by calibrating the fragilisation heat treatment so that the fragilisation plane has a maturation rate at least equal to a target maturation rate.

12. A method according to one of the preceding claims, wherein the first substrate (1) consists of a disk-shaped wafer, and wherein the central zone comprises the geometric center of the wafer.

13. A method according to preceding claims, wherein the peripheral zone consists of an annular zone, the inner radius of circle of which is greater than 2/3, and preferably greater than 80%, of the radius of the first substrate (1).

14. A method according to the preceding claim, wherein the peripheral zone is totally encompassed in one exclusion zone of the useful layer (3).

a)

b)

c)

d)

FIG. 1: Art Antérieur

FIG. 2: Art antérieur

FIG. 3

FIG. 4

FIG. 5a

FIG. 5b

## RÉFÉRENCES CITÉES DANS LA DESCRIPTION

**Documents brevets cités dans la description**

- FR 3020175
- US 2010330779 A
- WO 2013140065 A

**Littérature non-brevet citée dans la description**

- Yield Management Solution. **F. HOLSTEYNS.** Seeing through the haze. Spring, 2004, 50-54
- **D. MASSY et al.** fracture dynamics in implanted silicon. *Applied Physics Letters,* 2015, vol. 107